Europäisches Patentamt

European Patent Office

Office européen des brevets

(19)

(11) **EP 1 118 006 B1**

(12) **EUROPÄISCHE PATENTSCHRIFT**

(45) Veröffentlichungstag und Bekanntmachung des Hinweises auf die Patenterteilung:
**23.11.2005  Patentblatt 2005/47**

(21) Anmeldenummer: **99969498.7**

(22) Anmeldetag: **20.09.1999**

(51) Int Cl.$^7$: **G01R 31/26**

(86) Internationale Anmeldenummer:
**PCT/DE1999/003004**

(87) Internationale Veröffentlichungsnummer:
**WO 2000/017664 (30.03.2000 Gazette 2000/13)**

(54) **VERFAHREN UND VORRICHTUNG ZUM TESTEN VON AUF EINEM HALBLEITERCHIP INTEGRIERTEN KONDENSATOREN**

METHOD AND DEVICE FOR TESTING CAPACITORS INTEGRATED ON A SEMICONDUCTOR CHIP

PROCEDE ET DISPOSITIF PERMETTANT DE TESTER DES CONDENSATEURS INTEGRES A UNE PUCE SEMI-CONDUCTRICE

(84) Benannte Vertragsstaaten:
**AT DE FR GB**

(30) Priorität: **22.09.1998  DE 19843469**

(43) Veröffentlichungstag der Anmeldung:
**25.07.2001  Patentblatt 2001/30**

(73) Patentinhaber: **Infineon Technologies AG**
**81669 München (DE)**

(72) Erfinder:
 • **LEINEWEBER, Hubert**
  **D-81379 München (DE)**

 • **OTTERSTEDT, Jan**
  **D-81673 München (DE)**
 • **SMOLA, Michael**
  **D-80636 München (DE)**

(74) Vertreter: **Epping - Hermann - Fischer**
**Ridlerstrasse 55**
**80339 München (DE)**

(56) Entgegenhaltungen:
**US-A- 5 175 547      US-A- 5 789 964**
**US-A- 5 885 846      US-A- 5 991 905**

Anmerkung: Innerhalb von neun Monaten nach der Bekanntmachung des Hinweises auf die Erteilung des europäischen Patents  kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Das Testen von analogen Komponenten innerhalb von Schaltungen, insbesondere die Überprüfung von Kondensatoren, die Teil einer integrierten Schaltung sind, ist sehr aufwendig. Insbesondere das Testen innerhalb der Produktion integrierter Schaltungen ist sehr zeitraubend und benötigt eine besondere Testausrüstung, die daher meist sehr teuer ist. Außerdem sind in der Regel auf dem die integrierte Schaltung und die Kondensatoren aufweisenden Halbleiterchip analoge zusätzliche Testpins erforderlich, die im bestimmungsgemäßen Betrieb nicht mehr gebraucht werden. Weiterhin müssen die zu testenden Kondensatoren durch spezielle aufwendige Schaltungsteile freigeschaltet und so konfiguriert werden, daß sie gezielt durch die Testpins erreicht werden können. Diese Form des Tests ist sehr aufwendig und gestattet nur ein begrenztes Maß an Parallelisierung, was zur Folge hat, daß die Testzeiten pro Einzelchip sehr groß werden.

Aus der US 5 175 547 A sind ein Verfahren und eine Vorrichtung zum Testen eines Analog-/Digital-Wandlers mit Kondensatoren bekannt. Zum schnellen Testen der Kondensatoren wird eine Kondensatortestlogik eingesetzt, die den Test durch einfache AND- und OR-Operationen durchführt.

Aus der US 4 072 938 A, die als nächstliegender Stand der Technik angesehen werden kann, ist ein Analog-/DigitalWandler mit zwei parallelen Strängen, die jeweils eine Eimerkettenschaltung bilden, bekannt. Je Eimerkettenschaltung wird von Kondensatoren, die der Reihe nach mit Nummern von 1 bis (N-1) versehen werden können, jeder der ungeradzahligen Kondensatoren über jeweils ein Schaltelement mit dem jeweils nächsthöheren geradzahligen Kondensator verbunden, wobei die Schaltelemente über eine gemeinsame Steuerleitung ansteuerbar sind. Jeder der geradzahligen Kondensatoren wird über jeweils ein Schaltelement mit dem jeweils nächsthöheren ungeradzahligen Kondensator verbunden, wobei auch diese Schaltelemente über eine gemeinsame Steuerleitung ansteuerbar sind. In einem der Stränge wird ein zu wandelnder Eingangswert verarbeitet, während in dem parallelen Strang ein Referenzwert verarbeitet wird. In jeder Stufe, auch der letzten, findet ein Vergleich zwischen beiden Strängen statt.

Die Aufgabe der Erfindung ist es, ein Verfahren für das Testen von Komponenten anzugeben, mit dem die für das Testen benötigte Zeit verringert werden kann und das daher billiger ist. Ebenso soll eine Vorrichtung angegeben werden, bei der ein schnelles und daher billiges Testen von Komponenten möglich ist.

Die Aufgabe wird durch ein Verfahren gemäß Anspruch 1 oder 3 bzw. eine Vorrichtung gemäß Anspruch 4 oder 8 gelöst. Vorteilhafte Weiterbildungen sind in den Unteransprüchen angegeben.

Durch das erfindungsgemäße Verfahren und die Vorrichtung zur verfeinerten Anwendung des Prinzips des Ladungstransports über sogenannte Eimerketten wird der Aufwand zum Testen integrierter Kondensatoren erheblich verringert. Es wird dabei dieses Eimerkettenprinzip in vorteilhafter Weise mit einem Netzwerk von Schaltern und einem Komparator kombiniert.

Die Erfindung soll nachfolgend anhand eines Ausführungsbeispiels mit Hilfe einer Figur näher erläutert werden.

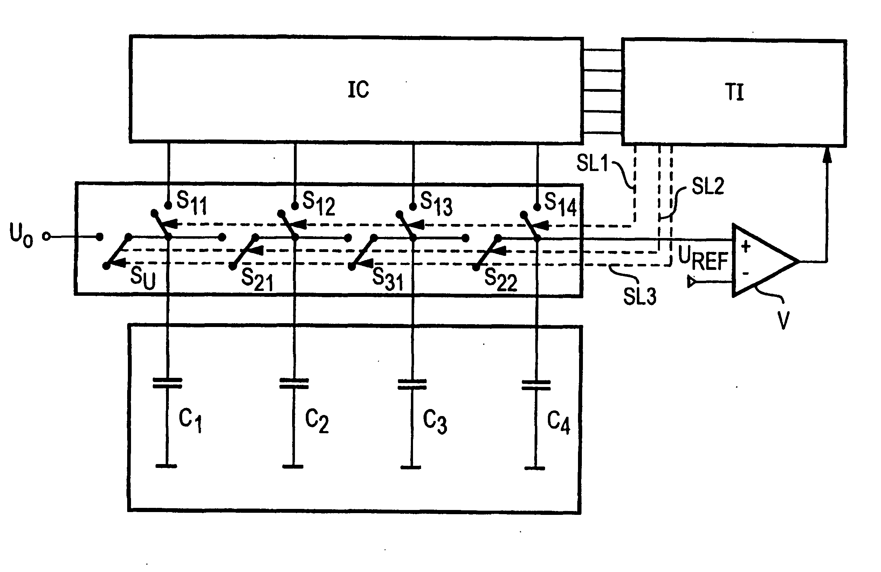

Die Figur zeigt in schematischer Weise eine integrierte Schaltung IC die zusammen mit im Beispiel vier Kondensatoren $C_1...C_4$ auf einem Halbleiterchip integriert ist. Zum Funktionstest der Kondensatoren $C_1...C_4$ ist eine erste Gruppe von vier Schaltelementen $S_{11}...S_{14}$ vorgesehen, wobei jeder der . Kondensatoren $C_1...C_4$ über eines dieser Schaltelemente $S_{11}...S_{14}$ mit der integrierten Schaltung IC verbunden ist bzw. mittels dieses Schaltelements von der integrierten Schaltung IC getrennt werden kann. Die Schaltelemente $S_{11}...S_{14}$ der ersten Schaltelementgruppe sind steuerbar ausgebildet und ihre Steueranschlüsse sind über eine erste Steuerleitung SL1 mit einer Teststeuerschaltung TI verbunden.

Die Teststeuerschaltung TI kann dabei fest verdrahtet oder als Mikroprozessor realisiert und auf dem Halbleiterchip mitintegriert sein. Dies ermöglicht einen automatischen Testablauf. Insbesondere ist ein parallel zu anderen Vorgängen ablaufender Kondensatortest möglich, was eine deutliche Verringerung der Testzeit pro Schaltkreis zur Folge hat.

Es ist aber auch möglich, als Teststeuerschaltung einen Steuercomputer wie beispielsweise einen herkömmlichen PC zu verwenden, der über Chipanschlüsse mit Steuerleitungen SL1, SL2, SL3 auf dem Halbleiterchip verbunden werden kann.

Die Kondensatoren $C_1...C_4$ sind über weitere steuerbare Schaltelemente $S_{21}$, $S_{31}$, $S_{22}$ miteinander derart verbunden, daß der erste Kondensator $C_1$ über ein erstes Schaltelement $S_{21}$ mit dem zweiten Kondensator $C_2$, der zweite Kondensator $C_2$ über ein zweites Schaltelement $S_{31}$ mit dem dritten Kondensator $C_3$ und der dritte Kondensator $C_3$ über ein drittes Schaltelement $S_{22}$ mit dem vierten Kondensator $C_4$ verbunden ist. Die jeweils nicht mit Schaltelementen verbundenen Anschlüsse der Kondensatoren $C_1...C_4$ sind mit dem Masseanschluß verbunden.

Die Schaltelemente $S_{21}$ und $S_{22}$ bilden dabei eine zweite Gruppe von Schaltelementen und das Schaltelement $S_{31}$ eine dritte Gruppe von Schaltelementen.

Bei einer größeren Anzahl von N Schaltelementen dienen die Schaltelemente der zweiten Schaltelementgruppe $S_{21}$, $S_{22}$, $S_{23}$ ... dazu, die ungeradzahligen Kondensatoren $C_1$, $C_3$, $C_5...$ mit den jeweils nächsthöheren geradzahligen Kondensatoren $C_2$, $C_4$, $C_6...$ zu verbinden.

Die Schaltelemente der dritten Schaltelementgruppe $S_{31}$, $S_{32}...$ dienen dazu, die geradzahligen Kondensatoren $C_2$, $C_4$, $C_6...$ mit den nächsthöheren ungeradzahligen Kondensatoren $C_3$, $C_5$, $C_7...$ zu verbinden,

so daß eine Kondensator-Schalter-Kette, eine sogenannte Eimerkette, entsteht.

Der erste Kondensator $C_1$ kann über ein weiteres Schaltelement $S_U$ mit einer Spannung Uo verbunden werden, während der vierte Kondensator $C_4$ bzw. bei N Kondensatoren der letzte Kondensator $C_N$ mit einem Eingangsanschluß eines Komparators V verbunden ist. Der andere Eingangsanschluß des Komparators V ist mit einer Referenzspannung $U_{ref}$ beaufschlagt.

Die Referenzspannung $U_{ref}$ kann dabei veränderbar sein und von der Teststeuerschaltung TI erzeugt werden. Der Ausgangsanschluß des Komparators V ist mit der Teststeuerschaltung TI verbunden. Die an ihm anliegende Spannung gibt an, ob die Spannung am letzten Kondensator der Eimerkette ober- oder unterhalb der Referenzspannung $U_{ref}$ liegt und somit, ob alle Kondensatoren intakt sind oder nicht.

Zur Weiterleitung von auf den Kondensatoren $C_1...C_4$ befindlichen Ladungen nach dem Eimerkettenprinzip sind die Steueranschlüsse der Schaltelemente der ersten Gruppe $S_{21}$, $S_{22}$ über eine zweite Steuerleitung SL2 und die Steueranschlüsse der Schaltelemente der dritten Gruppe $S_{31}$ über eine dritte Steuerleitung SL3 mit der Teststeuerschaltung TI verbunden. Der Steueranschluß des weiteren Schaltelements $S_U$ ist ebenfalls mit der dritten Steuerleitung SL3 verbunden.

Die Ansteuerung der Schaltelemente erfolgt derart, daß zunächst alle Kondensatoren $C_1...C_4$ entladen werden, indem beispielsweise alle Schaltelemente der ersten Gruppe $S_{11}...S_{14}$ über die erste Steuerleitung SL1 geschlossen werden und die Kondensatoren $C_1...C_4$ innerhalb der integrierten Schaltung IC mit Masse verbunden werden. Danach werden die Kondensatoren $C_1...C_4$ durch Öffnen der Schaltelemente der ersten Schaltelementgruppe $S_{11}.....S_{14}$ von der integrierten Schaltung IC getrennt. Anschließend werden die Schalter der dritten Schaltelementgruppe $S_{31}$ und das weitere Schaltelement $S_U$ über die dritte Steuerleitung SL3 geschlossen, so daß aufgrund einer am weiteren Schalter $S_U$ anliegenden Spannung $U_0$ eine Ladung auf den ersten Kondensator $C_1$ aufgebracht wird. Daraufhin werden die Schaltelemente der dritten Schaltelementgruppe $S_{31}$ und das weitere Schaltelement $S_U$ wieder geöffnet und über die Steuerleitung SL2 die Schaltelemente der zweiten Schaltelementgruppe $S_{21}$, $S_{22}$ geschlossen, so daß ein Teil der sich auf dem ersten Kondensator $C_1$ befindenden Ladung auf den zweiten Kondensator $C_2$ weitertransportiert wird. Anschließend werden die Schaltelemente der zweiten Gruppe wieder geöffnet und die Schaltelemente der dritten Gruppe geschlossen und so weiter, bis ein vorbestimmter Teil der ursprünglich auf den ersten Kondensator $C_1$ aufgebrachten Ladung auf dem letzten Kondensator $C_4$ angelangt ist und mittels des Komparators V ausgewertet werden kann.

Je nach Größe der Kondensatoren $C_1...C_4$ läßt sich errechnen, welche Spannung bei intakten Kondensatoren zum Schluß beim letzten Kondensator $C_4$ erreicht werden muß.

Da die Schaltelemente der dritten Gruppe $S_{31}$ sowie das weitere Schaltelement $S_U$ und die Schaltelemente der zweiten Gruppe $S_{21}$, $S_{22}$ abwechselnd über die zweite und die dritte Steuerleitung SL2, SL3 angesteuert werden, ist es auch möglich, eine der Steuerleitungen einzusparen und die Schaltelemente derart auszubilden, daß die Schaltelemente der einen Gruppe mit einem High- und die Schaltelemente der anderen Gruppe mit einem Low-Pegel angesteuert werden können, die Schaltelemente der zweiten Schaltelementgruppe $S_{21}$, $S_{22}$ also ein zum Schaltverhalten der Schaltelemente der dritten Schaltelementgruppe $S_U$, $S_{31}$ inverses Schaltverhalten haben.

Im folgenden soll angegeben werden, wie sich die Spannung an den Kondensatoren einer Eimerkette bei gegebener Kapazität bei intakten Kondensatoren sowie bei Kondensatoren mit einem Defekt ändert:

Es sei n eine beliebige Anzahl von Kondensator mit der Kapazität

$$C_i = C_{max}*2^{-i} \text{ mit } i=[0..n-1].$$

Wird in diesem Fall der erste Kondensator mit der Kapazität $C_0$ mit der Spannung $V_0$ aufgeladen, ergibt sich mit

$$V_{i+1}=2/3*V_i$$

eine Spannung von

$$V_{n-1}= V_0{}^* (2/3 )^{n-1}.$$

Im Falle eines Defekts hat mindestens einer der Kondensatoren mit i=[0..n-2] eine falsche Kapazität

$$C_i = x*C_{isoll}.$$

In diesem Fall ergibt sich eine modifizierte Ausgangsspannung von

$$V_{n-1} = V_0{}^* (2/3)^{n-3} * 4x/ ((2x+1) * (2+x)).$$

Im Falle des Ausfalls des letzten Kondensators

$$(C_{n-1} = x*C_{n-1soll})$$

ergibt sich eine Ausgangsspannung von

$$V_{n-1} = V_0{}^* (2/3)^{n-2}*2/ (x+1).$$

Die Ansprechschwelle des Komparators ist abhängig von der zu testenden Konfiguration nach diesen Formeln wählbar. Dies ermöglicht ein breites Einsatzspektrum (z. B. variable Anzahl n, verschiedene Empfindlichkeiten...).

Es ist auch denkbar, mehr als einen Komparator einzusetzen und dadurch die Testabdeckung zu erhöhen.

Eine besonders günstige Variante könnte auch der Einsatz eines einfachen Transistors als Komparator sein, wobei die Ausgangsspannung so zu wählen wäre, daß die Schwellenspannung des Transistors die Grenze zwischen defekt und korrekt markiert.

**Patentansprüche**

1. verfahren zum Testen von N auf einem Halbleiterchip integrierten Kondensatoren ($C_1$....$C_N$; N>=3) mit den Schritten:

   a) Entladen aller Kondensatoren ($C_1$,...$C_N$),
   b) Aufladen eines ersten Kondensators ($C_1$),
   c) Verbinden des ersten Kondensators ($C_1$) mit einem zweiten Kondensator ($C_2$),
   d) Trennen des ersten und des zweiten Kondensators ($C_1$, $C_2$),
   e) Verbinden des zweiten Kondensators ($C_2$) mit einem dritten Kondensator ($C_3$),
   f) Fortfahren mit dem Trennen und Verbinden von Kondensatoren, bis der Nte Kondensator ($C_N$) mit dem (N-1) ten Kondensator ($C_{N-1}$) verbunden und wieder von ihm getrennt wurde,
   g) vergleichen der Spannung am Nten Kondensator ($C_N$) mit einer Referenzspannung (uref).

2. Verfahren nach Anspruch 1, **dadurch gekennzeichnet, daß** vor dem Durchführen des Schrittes g) die Schritte b) bis f) mehrmals wiederholt werden.

3. Verfahren zum Testen von N auf einem Halbleiterchip integrierten Kondensatoren ($C_1$, .... $C_N$; N>=3), wobei jedem der N Kondensatoren der Reihe nach eine Nummer von 1 bis N zugewiesen ist und die Kondensatoren, denen ungeradzahligen Nummern zugewiesen sind, als ungeradzahlige Kondensatoren, und die Kondensatoren, denen geradzahlige Nummern zugewiesen sind, als geradzahlige Kondensatoren gelten, mit den Schritten:

   a) Entladen aller Kondensatoren ($C_1$,...$C_N$),
   b) Aufladen eines ersten Kondensators ($C_1$),
   c) abwechselndes gleichzeitiges Verbinden entweder aller ungeradzahliger Kondensatoren ($C_1$, $C_3$, ...$C_{N-1}$) mit den nächsthöheren geradzahligen Kondensatoren ($C_2$, $C_4$,...$C_N$) oder aller geradzahliger Kondensatoren ($C_2$, $C_4$,...$C_{N-2}$) mit den nächsthöheren ungeradzahligen Kondensatoren ($C_3$, $C_5$, ...$C_{N-1}$) bis eine Ladung vom ersten ($C_1$) zum Nten Kondensator ($C_N$) übertragen ist,
   d) Vergleichen der Spannung am Nten Kondensator ($C_N$) mit einer Referenzspannung (Uref).

4. Vorrichtung zum Testen von N auf einem Halbleiterchip integrierten Kondensatoren ($C_1$,...$C_N$; N>=3), wobei jedem der N Kondensatoren der Reihe nach eine Nummer von 1 bis N zugewiesen ist und die Kondensatoren, denen ungeradzahligen Nummern zugewiesen sind, als ungeradzahlige Kondensatoren, und die Kondensatoren, denen geradzahlige Nummern zugewiesen sind, als geradzahlige Kondensatoren gelten, wobei von den Kondensatoren mit den Nummern 1 bis N-1

   - alle ungeradzahligen Kondensatoren ($C_1$, $C_3$, $C_5$,...) über steuerbare, einer zweiten Schaltelement-Gruppe angehörende Schaltelemente ($S_{21}$, $S_{22}$...) mit dem nächsthöheren geradzahligen Kondensator ($C_2$, $C_4$, $C_6$, ...) und
   - alle geradzahligen Kondensatoren ($C_2$, $C_4$, $C_6$, ...) über steuerbare, einer dritten Schaltelement-Gruppe angehörende Schaltelemente ($S_{31}$, ...) mit dem nächsthöheren ungeradzahligen Kondensator ($C_3$, $C_5$, $C_7$,...) verbunden sind und
   - der erste Kondensator ($C_1$) über ein weiteres Schaltelement ($S_U$) mit einer Spannungsquelle ($U_0$) verbunden ist, und
   - der Nte Kondensator ($C_N$) mit einem die Spannung am Nten Kondensator mit einer Referenzspannung ($U_{ref}$) vergleichen den Komparator (V) verbunden ist,

   **dadurch gekennzeichnet, dass**
   jeder der Kondensatoren ($C_1$, ...$C_N$) über je ein steuerbares, einer ersten Schaltelement-Gruppe ($S_{11}$...$S_{14}$) angehörendes Schaltelement mit einer auf dem Halbleiterchip integrierten Schaltung (IC) verbunden ist,
   jede Schaltelement-Gruppe ($S_{11}$ ... $S_{14}$; $S_{21}$, $S_{22}$...; $S_{31}$, ...) über eine jeweilige Steuerleitung (SL1, SL2, SL3) mit einer Teststeuerschaltung (TI) verbunden ist,
   das weitere Schaltelement ($S_U$) zusammen mit der dritten Schaltelement-Gruppe ($S_{31}$, ...) mit der Teststeuerschaltung (TI) verbunden ist und
   die Kondensatoren ($C_1$,...$C_N$) durch Ansteuerung der Schaltelemente der ersten Schaltelement-Gruppe ($S_{11}$...$S_{14}$) durch die Teststeuerschaltung (TI) in einen Funktionstest schaltbar sind.

5. Vorrichtung nach Anspruch 4, **dadurch gekennzeichnet, daß** die Teststeuerschaltung (TI) auf dem Halbleiterchip integriert ist.

6. Vorrichtung nach Anspruch 5, **dadurch gekenn-**

**zeichnet, daß** die Teststeuerschaltung (TI) ein durch ein Testprogramm gesteuerter Mikroprozessor ist.

7. Vorrichtung nach Anspruch 4, **dadurch gekennzeichnet, daß** die Teststeuerschaltung (TI) ein Steuercomputer ist.

8. Vorrichtung nach Anspruch 4, **dadurch gekennzeichnet, daß** die Schaltelemente der zweiten Schaltelement-Gruppe ($S_{21}$, $S_{22}$...) ein zum Schaltverhalten der Schaltelemente der dritten Schaltelement-Gruppe ($S_{31}$, ...) und des weiteren Schaltelements ($S_U$) inverses Schaltverhalten aufweisen und die Schaltelemente der zweiten und der dritten Schaltelement-Gruppe über nur eine Steuerleitung anstelle von zwei Steuerleitungen ansteuerbar sind.

9. Vorrichtung nach einem der Ansprüche 4 bis 8, **dadurch gekennzeichnet, daß** der Komparator (V) als Transistor ausgebildet ist.

**Claims**

1. Method for testing N capacitors ($C_1$, ... $C_N$; N>=3) integrated on a semiconductor chip, having the steps of:

   a) discharging all the capacitors ($C_1$, ... $C_N$),
   b) charging a first capacitor ($C_1$),
   c) connecting the first capacitor ($C_1$) to a second capacitor ($C_2$),
   d) disconnecting the first and second capacitors ($C_1$, $C_2$),
   e) connecting the second capacitor ($C_2$) to a third capacitor ($C_3$),
   f) continuing with the disconnection and connection of capacitors until the N-th capacitor ($C_N$) has been connected to the (N-1) -th capacitor ($C_{N-1}$) and disconnected from it again,
   g) comparing the voltage across the N-th capacitor ($C_N$) with a reference voltage (Uref).

2. Method according to Claim 1, **characterized in that** steps b) to f) are repeated a number of times before step g) is carried out.

3. Method for testing N capacitors ($C_1$, ... $C_N$; N>=3) integrated on a semiconductor chip, a number from 1 to N being allocated to each of the N capacitors in order and the capacitors allocated odd numbers being regarded as odd-numbered capacitors and the capacitors allocated even numbers being regarded as even-numbered capacitors, having the steps of:

   a) discharging all the capacitors ($C_1$, ... $C_N$),
   b) charging a first capacitor ($C_1$),
   c) alternately simultaneously connecting either all the odd-numbered capacitors ($C_1$, $C_3$, ... $C_{N-1}$) to the next-higher even-numbered capacitors ($C_2$, $C_4$, ... $C_N$) or all the even-numbered capacitors ($C_2$, $C_4$, ... $C_{N-2}$) to the next-higher odd-numbered capacitors ($C_3$, $C_5$, ... $C_{N-1}$) until a charge has been transferred from the first ($C_1$) to the N-th capacitor ($C_N$),
   d) comparing the voltage across the N-th capacitor ($C_N$) with a reference voltage (Uref).

4. Device for testing N capacitors ($C_1$, ... $C_N$; N>=3) integrated on a semiconductor chip, a number from 1 to N being allocated to each of the N capacitors in order and the capacitors allocated odd numbers being regarded as odd-numbered capacitors and the capacitors allocated even numbers being regarded as even-numbered capacitors, in which case, from the capacitors having the numbers 1 to N-1,

   - all the odd-numbered capacitors ($C_1$, $C_3$, $C_5$, ...) are connected to the next-higher even-numbered capacitor ($C_2$, $C_4$, $C_6$, ...) via controllable switching elements ($S_{21}$, $S_{22}$ ...) associated with a second switching element group, and
   - all the even-numbered capacitors ($C_2$, $C_4$, $C_6$, ...) are connected to the next-higher odd-numbered capacitor ($C_3$, $C_5$, $C_7$, ...) via controllable switching elements ($S_{31}$, ...) associated with a third switching element group, and
   - the first capacitor ($C_1$) is connected to a voltage source ($U_0$) via a further switching element ($S_U$), and
   - the N-th capacitor ($C_N$) is connected to a comparator (V), which compares the voltage across the N-th capacitor with a reference voltage ($U_{ref}$),

   **characterized in that**
   each of the capacitors ($C_1$, ... $C_N$) is connected to a circuit (IC) integrated on the semiconductor chip via a respective controllable switching element associated with a first switching element group ($S_{11}$ ... $S_{14}$),
   each switching element group ($S_{11}$ ... $S_{14}$; $S_{21}$, $S_{22}$...; $S_{31}$, ...) is connected to a test control circuit (TI) via a respective control line (SL1, SL2, SL3),
   the further switching element ($S_U$) is connected together with the third switching element group ($S_{31}$, ...) to the test control circuit (TI), and
   the capacitors ($C_1$, ... $C_N$) can be switched into a functional test by the driving of the switching elements of the first switching element group ($S_{11}$ ... $S_{14}$) by the test control circuit (TI).

**5.** Device according to Claim 4, **characterized in that** the test control circuit (TI) is integrated on the semiconductor chip.

**6.** Device according to Claim 5, **characterized in that** the test control circuit (TI) is a microprocessor controlled by a test program.

**7.** Device according to Claim 4, **characterized in that** the test control circuit (TI) is a control computer.

**8.** Device according to Claim 4, **characterized in that** the switching elements of the second switching element group ($S_{21}$, $S_{22}$ ...) have a switching behaviour which is the inverse of the switching behaviour of the switching elements of the third switching element group ($S_{31}$, ...) and of the further switching element ($S_U$) and the switching elements of the second and third switching element groups can be driven via only one control line instead of two control lines.

**9.** Device according to one of Claims 4 to 8, **characterized in that** the comparator (V) is designed as a transistor.

**Revendications**

**1.** Procédé permettant de tester N condensateurs ($C_1$, ... $C_N$ ; N>=3) intégrés sur une puce à semi-conducteurs, comprenant les stades dans lesquels :

a) on décharge tous les condensateurs ($C_1$, ... $C_N$),
b) on charge un premier condensateur ($C_1$),
c) on relie le premier condensateur ($C_1$) à un deuxième condensateur ($C_2$),
d) on sépare le premier et le deuxième condensateur ($C_1$, $C_2$),
e) on relie le deuxième condensateur ($C_2$) à un troisième condensateur ($C_3$),
f) on poursuit la séparation et la liaison des condensateurs jusqu'à ce que le Nième condensateur ($C_N$) soit relié au (N-1) ième condensateur ($C_{N-1}$) et en ait été à nouveau séparé,
g) on compare la tension aux bornes du Nième condensateur ($C_N$) à une tension (Uref) de référence.

**2.** Procédé suivant la revendication 1, **caractérisé en ce qu'**avant d'effectuer le stade g) on répète plusieurs stades les sates b) à f).

**3.** Procédé permettant de tester N condensateurs ($C_1$, ... $C_N$ ; N>=3) intégrés sur une puce à semi-conducteurs, un numéro de 1 à N étant affecté à chacun des condensateurs suivant leur ordre de succession et les condensateurs auxquels sont affectés des numéros impairs sont considérés comme étant des condensateurs impairs et les condensateurs auxquels sont affectés des numéros pairs sont considérés comme des condensateurs pairs, comprenant les stades :

a) on décharge tous les condensateurs ($C_1$, ... $C_N$),
b) on charge un premier condensateur ($C_1$),
c) on relier simultanément en alternance, soit tous les condensateurs ($C_1$, $C_3$, ... $C_{N-1}$) impairs aux condensateurs ($C_2$, $C_4$, ... $C_N$) pairs de rang immédiatement supérieur soit tous les condensateurs ($C_2$, $C_4$, ... $C_{N-2}$) pairs aux condensateurs ($C_3$, $C_5$, ... $C_{N-1}$) impairs de rang immédiatement supérieur jusqu'à ce qu'une charge soit transmise du premier ($C_1$) au Nième condensateur ($C_N$),
d) on compare la tension aux bornes du Nième condensateur ($C_N$) à une tension (Uref) de référence.

**4.** Dispositif permettant de tester N condensateurs ($C_1$,

**...** $C_N$ ; N>=3) intégrés sur une puce à semi-conducteurs, un numéro de 1 à N étant affecté à chacun des condensateurs suivant leur ordre de succession et les condensateurs auxquels sont affectés des numéros impairs sont considérés comme étant des condensateurs impairs et les condensateurs auxquels sont affectés des numéros pairs sont considérés comme des condensateurs pairs,

dans lequel parmi les condensateurs ayant les numéros 1 à N-1

- tous les condensateurs ($C_1$, $C_3$, $C_5$, ...) impairs sont reliés par des éléments ($S_{21}$, $S_{22}$, ...) de commutation pouvant être commandés et appartenant à un deuxième groupe d'éléments de commutation aux condensateurs ($C_2$, $C_4$, $C_6$, ...) pairs de rang immédiatement supérieur et
- tous les condensateurs ($C_2$, $C_4$, $C_6$, ...) pairs sont reliés par des éléments ($S_{31}$, ...) de commutation pouvant être commandés et appartenant à un troisième groupe d'éléments de commutation aux condensateurs ($C_3$, $C_5$, $C_7$, ...) impairs de rang immédiatement supérieur et
- le premier condensateur ($C_1$) est relié par un autre élément ($S_U$) de commutation à une source ($U_0$) de tension, et
- le Nième condensateur ($C_N$) est relié à un comparateur (V) comparant la tension aux bornes du Nième condensateur à une tension ($U_{ref}$) de référence,

**caractérisé en ce que**
chacun des condensateurs ($C_1$, ... $C_N$) est relié par respectivement un élément de commutation pouvant être commandé et appartenant à un premier groupe ($S_{11}$ ... $S_{14}$) d'éléments de commutation à un circuit (IC) intégré sur la puce à semi-conducteur,
chaque groupe ($S_{11}$ ... $S_{14}$ ; $S_{21}$ ... ; $S_{31}$, ...) d'éléments de commutation est relié par une ligne (SL1, SL2, SL3) de commande respective à un circuit (TI) de commande de test,
l'autre élément ($S_U$) de commutation est relié ensemble avec le troisième groupe ($S_{31}$ ...) d'éléments de commutation au circuit (TI) de commande de test et
les condensateurs ($C_1$ , ... $C_N$) peuvent être commutés dans une fonction de test par commande des éléments de commutation du premier groupe ($S_{11}$ ... $S_{14}$) d'éléments de commutation par le circuit (TI) de commande de test.

5. Dispositif suivant la revendication 4, **caractérisé en ce que** le circuit (TI) de commande de test est intégré sur la puce à semi-conducteur.

6. Dispositif suivant la revendication 5, **caractérisé en ce que** le circuit (TI) de commande de test est un microprocesseur commandé par un programme de test.

7. Dispositif suivant la revendication 4, **caractérisé en ce que** le circuit (TI) de commande de test est un ordinateur de commande.

8. Dispositif suivant la revendication 4, **caractérisé en ce que** les éléments de commutation du deuxième groupe ($S_{21}$, $S_{22}$ ...) d'éléments de commutation ont un comportement de commutation inverse du comportement de commutation des éléments de commutation du troisième groupe ($S_{31}$, ...) d'éléments de commutation et de l'autre élément ($S_U$) de commutation et les éléments de commutation du deuxième et du troisième groupe d'éléments de commutation peuvent être commandés par seulement une ligne de commande au lieu de pouvoir l'être par deux lignes de commande.

9. Dispositif suivant l'une des revendications 4 à 8, **caractérisé en ce que** le comparateur (V) est constitué sous la forme d'un transistor.